# EUROPEAN PATENT APPLICATION

(11) **EP 4 371 932 A1**
(43) Date of publication of application: **22.05.2024**
(21) Application number: 22208123.4
(22) Date of filing: 17.11.2022
(51) Int. Cl.: B82Y 10/00, H01L 29/40, H01L 29/423, H01L 29/66

(54) **A METHOD FOR PRODUCING CLOSELY SPACED GATE STRUCTURES OF A QUANTUM DOT DEVICE**

(71) Applicant: Imec VZW, 3001 Leuven (BE)
(72) Inventor: BAUDOT, Mr. Sylvain, 1200 Woluwe Saint-Lambert (BE); KUBICEK, Mr. Stefan, 3212 Pellenberg (BE); MASSAR, Ms. Shana, 3050 Oud-Heverlee (BE)
(74) Representative: Patent Department IMEC

(57) **Abstract**

According to the method of the invention, a plurality of mutually parallel mandrel structures (4,4') is produced on a substrate (1) comprising at least a top layer of semiconductor material. Side spacers (5) are formed on the mandrel structures, and the mandrel structures are removed with respect to the spacers. This involves the formation of an auxiliary layer on the substrate, that enables the selective removal of at least a top portion of the mandrels, followed by the removal of the auxiliary layer and possibly any remaining portions of the mandrels. The gate oxide (10) of a quantum dot device is formed in the areas between the spacers, by a thermal oxidation of the semiconductor material of the substrate. The thermal oxidation enables the formation of a gate oxide having low defect density and a constant thickness. The spacer material (5) is chosen to withstand the thermal oxidation and acts as an insulator between the gate structures (15). The formation of the gate structures (15) as such is done by techniques taken from or similar to the known replacement gate technology.

## Description

### Field of the Invention

The present invention is related to methods for producing a quantum dot device on a semiconductor substrate, in particular to a novel way of producing the closely spaced gate structures of the device, separated by a thin insulator.

### State of the art.

Quantum dot devices on semiconductor material have been explored extensively in recent years, as one of the main avenues towards realizing a workable quantum computing chip. Various architectures have been explored, which all have in common the presence of closely spaced gates separated by an insulator and configured so that quantum dots can be confined underneath one or more of these gates. The gates may for example be metal gates formed on a thin layer of silicon oxide lying on a silicon substrate. By the close spacing of the gates and by applying appropriate voltages to the gates, it is possible to create quantum dots underneath the gates, i.e. small isolated electron or hole islands, at the interface between the silicon oxide and the silicon substrate, and to manipulate qubits associated with the quantum dots. The qubits may for example be defined by the spin state of individual electrons of the quantum dots. Magnetic resonance is used to control the spin states, and a read-out device, for example a single electron transistor, may be integrated in the vicinity of the quantum dot or dots. The quantum dot device is operated at a temperature at Kelvin or sub-Kelvin range (i.e. about 1K or less), in order to enable sufficient qubit coherence times and qubit-based computations.

One recurring problem common to various configurations which answer to the above description is related to the manufacturing process for realizing the closely spaced and nano-scaled gate array. The gate widths are required to be in the range of a few tens of nanometres while the insulator spacing between the gates must be as small as possible, preferably between about 5 nm and 20 nm. Currently applied methods for producing such a structure include the use of consecutive gate patterning steps resulting in partly overlapping gates, or the use of techniques similar to multiple patterning. A common problem to all currently applied methods is the fact that the substrate onto which the gates are formed is exposed once or multiple times to plasma etching during the fabrication process. Such exposure is likely to damage the substrate resulting in a deterioration of the qubit states. The gate formation by multiple patterning steps also results in non-uniform dielectric spacing between the gates and in non-uniform gate heights, which may be detrimental for the device operation.

When the gates are formed on silicon oxide, this oxide needs to be of low defect density in order for the qubit device to work properly. In current fabrication methods using consecutive gate patterning steps, oxide is deposited by atomic layer deposition after each step. This type of deposition does however not result in the required defect free characteristics of the oxide, so that the quality of the gate oxide progressively worsens at each consecutive gate formation.

### Summary of the invention

The invention aims to provide a method that enables to produce closely spaced gate structures of a quantum dot device, without the problems highlighted above. This aim is achieved by a method as disclosed in the appended claims.

According to embodiments of the method of the invention, a plurality of mutually parallel mandrel structures is produced on a semiconductor substrate. Side spacers are formed on the mandrel structures, and the mandrel structures are removed relative to the spacers. This involves the formation of an auxiliary layer on the substrate, that enables the selective removal of at least a top portion of the mandrels, followed by the removal of the auxiliary layer and possibly any remaining portions of the mandrels. The gate oxide of a quantum dot device is then formed in the areas between the spacers, by a thermal oxidation of the semiconductor material of the substrate. The thermal oxidation enables the formation of a gate oxide having low defect density and a constant thickness. The spacer material is chosen to withstand the thermal oxidation and acts as an insulator between adjacent gate structures. The formation of these gate structures as such is done by techniques taken from or similar to the known replacement gate technology. As the structures are produced without requiring multiple patterning steps, this approach enables the formation of gate structures having an essentially uniform height and a uniform dielectric spacing.

The invention is in particular related to the method for producing a quantum dot device according to a pre-defined quantum dot device configuration, said configuration comprising an array of mutually parallel electrically conductive gate structures separated from each other by a dielectric-filled spacing the method comprising the steps of:
- providing a substrate consisting of a semiconductor material or comprising a top layer formed of a semiconductor material,
- producing a plurality of parallel mandrel structures on the substrate,
- producing spacers formed of a dielectric material on the side surfaces of the mandrel structures, said spacers having a given width,
- forming a thin auxiliary layer on the mandrel structures and on the substrate, said auxiliary layer being thinner than said spacer width,
- removing said auxiliary layer from the mandrel structures while substantially maintaining it on the substrate,
- selectively removing at least, a top layer of the mandrel structures, wherein said removal is selective with respect to the spacers and with respect to said auxiliary layer,
- removing said auxiliary layer from the substrate, and if any remaining portions of the mandrel structures are still present, removing said remaining portions,
- producing an oxide layer in the areas between the spacers, by thermal oxidation of said semiconductor material, wherein the oxide layer is thinner than the height of the spacers so that the spacers and the oxide layer define a topology,
- filling up the areas between the spacers by depositing one or more conformal layers which follow said topography, and thereafter depositing a non-conformal layer that covers the spacers,
- thinning and planarizing the non-conformal layer until structures are obtained, formed at least partially of the material of the non-conformal layer and separated from each other by at least said dielectric material of the spacers,
- starting from the result of the thinning and planarization step, producing said predefined quantum dot device configuration wherein:
   ∘ the structures or portions thereof act as the gate structures of the quantum dot device,
   ∘ the thermally grown oxide layer acts as a gate oxide layer,
   ∘ the spacers act as at least part of said dielectric-filled spacing between the gate structures.
The wording 'removal is selective with respect to the spacers' means that the width of the spacers is essentially maintained after said removal.

According to an embodiment, said auxiliary layer is a thin layer of oxide of said semiconductor material, and wherein said layer is formed by a thermal oxidation step.

According to an embodiment, the mandrel structures comprise a thin layer of oxide on the substrate and a thicker layer on top of the thin oxide layer, and wherein the method comprises:
- removing said thicker layer of the mandrel structures selectively with respect to the spacers and with respect to the thin auxiliary layer,
- thereafter, removing the thin oxide layer of the mandrel structures and the auxiliary layer prior to the step of forming the gate oxide layer.
The 'thin oxide layer' is preferably a layer of oxide of the semiconductor material of the substrate. The term 'thicker layer' means: a layer that is thicker, preferably considerably thicker than the thin oxide layer. The substrate may be a silicon substrate, or it may comprise a top layer formed of silicon.

According to an embodiment, the substrate is a silicon substrate or comprises a top layer formed of silicon, and the mandrel structures consist of said thin oxide layer, being a thin silicon oxide layer, and of said thicker layer formed of amorphous silicon or polycrystalline silicon.

According to an embodiment, the width of said mandrel structures is between 10 and 50 nm and wherein the width of the spacers is between 4 and 30 nm.

According to an embodiment, the mandrel structures all have the same width, and wherein said mandrel structures are arranged in a regular array having a constant pitch of at least twice said width.

According to an embodiment, the non-conformal layer is an electrically conductive layer, so that the structures obtained after thinning and planarization are electrically conductive structures.

According to an embodiment, the non-conformal layer is a non-electrically conductive layer, and wherein dopant elements are implanted in the structures obtained by thinning and planarization, so that said structures become electrically conductive.

According to an embodiment, one or more of the structures obtained after thinning and planarization are cut to form separate portions of said structures, and wherein one or more of said portions act as said gate structures of the quantum dot device.

The invention is equally related to a quantum dot device comprising an array of mutually parallel gate structures, said gate structures being separated from each other by a dielectric spacing and located on and in physical contact with a gate oxide layer that is on and in physical contact with a substrate, the substrate comprising at least a top layer formed of a semiconductor material, the gate oxide layer being formed of an oxide of said semiconductor material, characterized in that :
- the gate oxide layer has a constant thickness,
- the gate structures have essentially the same height,
- the width of the dielectric spacing is the same between each pair of adjacent gate structures and constant along the height of the gate structures.

According to an embodiment of the device, the substrate is a silicon substrate or comprises a top layer formed of silicon.

According to an embodiment of the device, the width of said gate structures is between 10 and 50 nm and wherein the width of the dielectric spacing is between 4 and 30 nm.

### Brief description of the figures

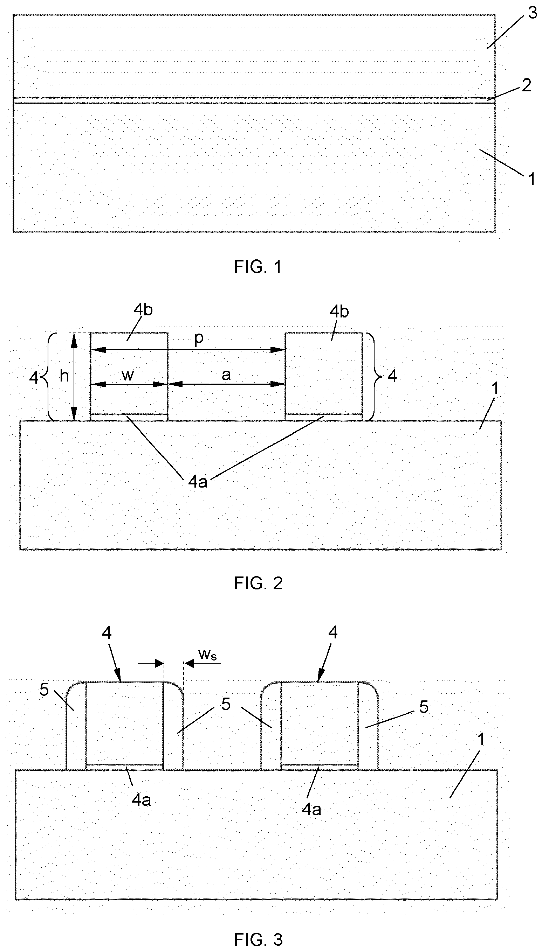

Figures 1 to 12 illustrate the method of the invention according to a particular embodiment using mandrel structures formed of a silicon-based material.

### Detailed description of embodiments of the invention

Figures 1 to 12 illustrate one embodiment of the method of the invention which will be described hereafter in detail. The materials and dimensions (specific values as well as ranges of values) stated in the description of this embodiment are given purely by way of example and are not limiting the scope of the invention. These materials and dimensions are suitable for producing an array of gate structures of a quantum dot device.

Figure 1 is a 2D cross-section view of a small area of a silicon substrate 1, which may be a crystalline silicon process wafer of 200 mm or 300 mm in diameter and of several hundreds of micrometres in thickness. On the surface of the Si wafer 1 is a thin silicon oxide (SiO₂) layer 2 which may have a thickness between 1 nm and 10 nm. Directly on the SiO₂ layer 2 is a layer 3 of amorphous silicon (aSi) having a thickness of about 50 nm. Standard and therefore well-known methods for producing the SiO₂ layer 2 and the aSi layer 3 on the Si wafer 1 may be applied. For example, layer 2 may be obtained by a thermal oxidation process of a standard silicon process wafer. Instead of an amorphous Si layer, layer 3 could be a layer of polycrystalline silicon (polySi) of similar thickness.

By standard lithography and etching techniques, the stack of layers 2 and 3 is patterned, as illustrated in Figure 2, resulting in the appearance of a plurality of parallel mandrel structures 4, formed of a thin oxide layer 4a and a portion 4b formed of aSi. The mandrel structures have a height h and a width w, and a length extending in the direction perpendicular to the drawing. In the exemplary embodiment shown, the pattern comprises 2 parallel mandrel structures 4 having the same width w of 40 nm and spaced apart by a distance a of 60 nm. The height h corresponds to the combined thickness of the original aSi layer 3 and the SiO₂ layer 2. The pitch p of the array is 100 nm.

According to preferred embodiments, the array comprises 2 or more mandrel structures 4, all having the same width w and spaced apart at a constant pitch p of more than twice the width of the features. Within the wider scope of the invention, the array may however consist of any number of parallel mandrel structures not necessarily having a constant width and pitch but spaced apart by a distance that enables the formation of gate structures suitable for a quantum dot device, by performing the steps of the invention as described hereafter and in the appended claims. The length of the mandrel structures 4 in the direction perpendicular to the drawing may be from a few tens of nanometres up to one or more micrometres.

Side spacers 5 formed of silicon nitride (hereafter abbreviated as SiN but intended to refer to the compound Si₃N₄ and possible stoichiometric variations thereof) are then formed on the sidewalls of the mandrel structures 4, as illustrated in Figure 3. The spacers 5 are also formed on the sidewalls which are parallel to the plane of the drawing. The width wₛ (indicated in Figure 3) of the spacers 5 is about 10nm in the embodiment shown. According to preferred embodiments of the invention, this spacer width is between 4 nm and 30 nm. Producing the spacers 5 can be realized by methods known in the art, for example from the field of multiple patterning. First, a layer of SiN is deposited conformally on the array of mandrel structures 4, i.e. the SiN layer follows the topology defined by the array and the surface of the substrate 1. This is followed by etching back the SiN layer so that it is removed from the top surfaces of the mandrel structures 4 and from the surface of the silicon substrate 1, while maintaining it on the vertical sidewalls of the mandrel structures 4. This can be done by a dry etching technique using plasma etching. Ample knowledge is available in the prior art about deposition techniques (for example atomic layer deposition, ALD) for forming the conformal SiN layer and subsequently applicable etch recipes for removing the SiN from the horizontal surfaces, therefore a precise description thereof is not needed here. The thickness of the conformally applied SiN layer and the etch parameters are controlled in such a manner that a spacer width of about 10nm is obtained. The upper surface of the spacers 8 is slightly curved downward relative to the upper surface of the mandrel structures 4 as a consequence of the dry etch process.

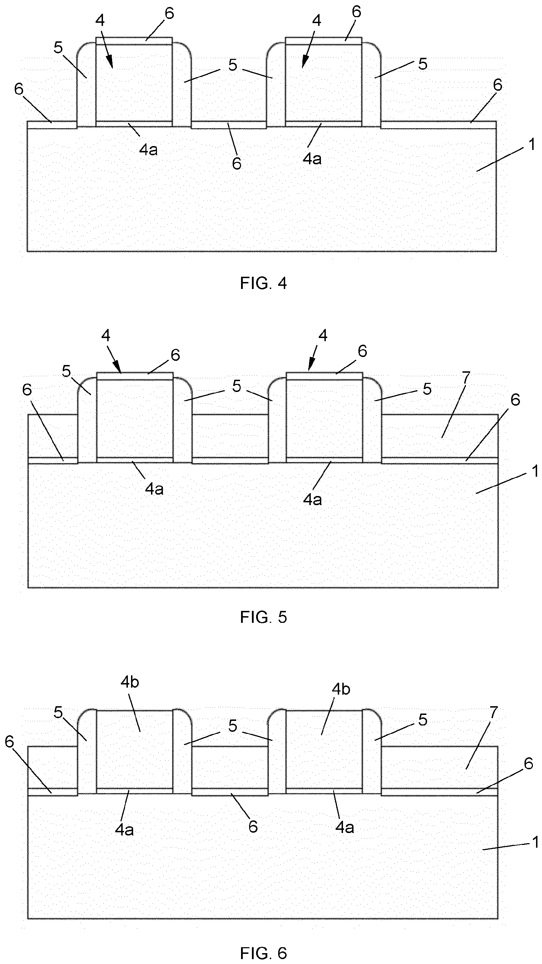

The next step according to this particular embodiment is a thermal oxidation step, wherein the substrate having the array of mandrel structures 4 and the spacers 5 on its surface is subjected to a temperature and environment suitable for oxidizing the amorphous Si of the mandrel structures 4 and the Si of the substrate. At the end of the thermal oxidation step, a thin silicon oxide layer 6 is formed on the substrate surface and on the upper surface of the mandrel structures 4, as illustrated in Figure 4. The thickness of the SiO₂ layer 6 may be between 1 nm and 10 nm, for example about 5 nm. The oxide layer 6 grows partly downward from the top level of the substrate 1 and of the aSi of the mandrel structures 4, i.e. it replaces part of the crystalline silicon at the top of the substrate 1 and part of the aSi at the top of the mandrel structures 4. The layer 6 also grows partly upwards beyond the original top levels of the substrate 1 and the mandrel structures 4, as visualized in the drawing. In the drawing, the upper surface of the layer 6 is at the same level as the upper surface of the layers 4a. This is however not a strict requirement and small level differences between these top surfaces are allowed within the scope of the invention.

Layer 6 is referred to as an 'auxiliary layer' in the appended claims. This layer is not limited to a thermally grown oxide layer, but it can be any layer that enables the selective removal of at least part of the mandrel structures with respect to this layer 6, as will be explained hereafter.

The SiN spacers 5 are not substantially oxidized during the thermal oxidation step. This is a characteristic of the method of the invention in terms of the material choice, taken in the first place in relation to a further thermal oxidation process applied later in the method of the invention. According to said characteristic, the material of the spacers 5 is chosen so that a thermal oxidation applied under conditions suitable for significantly oxidizing the material of the substrate 1 does not substantially oxidize the spacers 5. In the previous sentence, 'not substantially oxidize' means that an unavoidable small degree of oxidation may take place, forming a very thin oxide layer on the spacers 5, that is however not represented in the drawings.

Then a masking layer 7 is formed on the substrate 1 (see Figure 5), covering the oxide layer 6 on the substrate 1 while leaving the upper surfaces of the mandrel structures 4 exposed. The masking layer 7 may be a layer of bottom anti-reflective coating (BARC) material, deposited at a thickness higher than the height h of the mandrel structures 4, and subsequently etched back to a thickness in the order of or a little smaller than h/2.

With the BARC layer 7 in place, the substrate is subjected to wet etching using a hydrofluoric acid solution (known as HF etching or HF cleaning), which results in the removal of the SiO₂ layer 6 from the upper surface of the mandrel structures 4, as illustrated in Figure 6. Any oxide formed on the exposed portions of the spacers 5 is also removed. HF etching is known as such, and the required details of this treatment for removing the SiO₂ layer 6 are therefore not described here. This etching process selectively removes SiO₂ with respect to SiN, but the selectivity is never 100%. Hence the SiN may be removed to a small degree. As the layer 6 is very thin, this removal of SiN is not represented in the drawings.

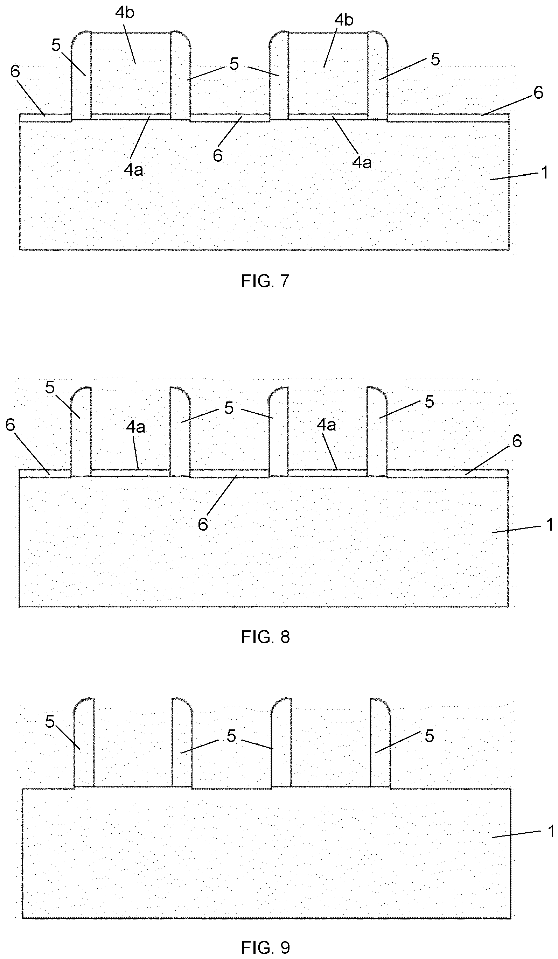

The BARC layer 7 is then stripped (also a standard process known as such), resulting in the condition illustrated in Figure 7. The thin SiO₂ layer 6 covers the surface of the Si substrate 1, while the mandrel structures 4 are no longer covered by such a SiO₂ layer.

This condition enables the selective removal of the aSi portion 4b of the mandrel structures 4 with respect to the spacers 5 and with respect to the oxide layer 6, by a selective etch recipe known as such in the art. This may be a wet etch process using tetramethyl ammonium hydroxide (TMAH) as the etchant. Etching silicon in TMAH is again a well-known process, the details of which need not be described here. The thin SiO₂ layer 6 prevents the Si of the substrate 1 from being removed. At the end of the selective etch process, an array of spacers 5 is left on the surface of the substrate 1, as shown in Figure 8, with thin SiO₂ layers 4a and 6 in between the spacers.

These SiO₂ layers 4a and 6 are then removed by another HF cleaning step, see Figure 9, again with a quasi-negligible removal of SiN (due to the small thickness of both layers 6 and 4a). A small difference in the level of the remaining surface portions of the substrate 1 is visible in Figure 9, as a consequence of the downward growth of the thermally grown layer 6. This level difference is somewhat exaggerated in the drawings in order to visualise it, but it could be so small as to be negligible given the fact that the thickness of layers 4a and 6 is very low, preferably less than 5 nm.

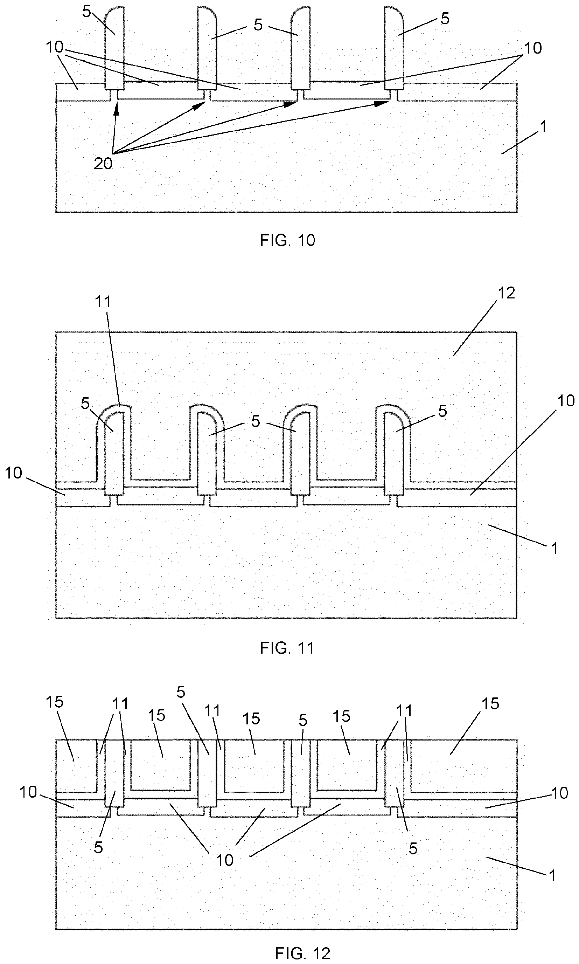

Then a further thermal oxidation step is applied, as was referred to already earlier. This further step is performed under conditions in terms of temperature and atmosphere suitable for growing a layer 10 of SiO₂ as illustrated in Figure 10. This oxide layer 10 grows partly downward and also upward to a certain degree. The downward growth results in the appearance of SiO₂ underneath at least part of the spacers 5, as is illustrated by the areas 20 in Figure 10, while the upward growth results in the base of the spacers 5 being enveloped by the oxide 10. The duration of this oxidation is such that the thickness of layer 10 enables the use of the layer as the gate oxide in the eventual quantum dot device. To this effect, the thickness of this layer is preferably between about 5 nm and 20 nm. The thermally grown oxide layer 10 is in any case thinner than the height of the spacers 5 (corresponding approximately to the height of the mandrel structures 4), so that the layer 10 and the spacers 5 define a topology characterized by the fact that the spacers 5 extend upwards from the upper surface of the oxide layer 10, as illustrated in Figure 10. According to embodiments of the invention, the thickness of the oxide layer 10 is lower than half the height of the spacers, or lower than ¼ of the height of the spacers.

As also illustrated in Figure 10, the level difference referred to earlier between different areas of the substrate in Figure 9 may be maintained as a level difference between different sections of layer 10 in Figure 10. However, this level difference may be very small or negligible due to the very low thicknesses of the initial layers 4a and 6. The thickness of the layer 10 is the same everywhere, i.e. layer 10 has a constant thickness.

The SiO₂ layer 10 is grown by thermal oxidation, i.e. by subjecting the substrate 1 to a high temperature, for example above 1000°C in an oxidizing atmosphere. This technique of producing an oxide layer results a high-quality oxide layer, i.e. a layer having a low defect density.

This layer 10 will serve as the gate oxide of the eventual quantum dot device. The way in which this layer is obtained, by growth at high temperature, enables the production of a quantum dot device having gate oxides of high quality and constant thickness across the device.

Following this and with reference to Figure 11, a conformal layer 11 is deposited on the topography defined by the spacers 5 and the SiO₂ layer 10. The conformal layer 11 may be a stack of several sublayers, the first of which is a dielectric, for example a high-k dielectric deposited directly on the spacers 5 and the SiO₂ layer 10. The conformal layer 11 may further comprise for example a TiN layer deposited on the high-k dielectric. Then a non-conformal electrically conductive layer 12 is deposited, i.e. a layer that does not follow the topography, but that fills the areas between the spacers 5 and forms a layer covering the spacers 5. Layer 12 may for example be a W layer. This layer 12 is subsequently thinned by etching and/or grinding and polishing methods until the spacers 5 are exposed, as illustrated in Figure 12. An upper portion of the spacers 5 is removed by the thinning process, resulting in an array of closely spaced electrically conductive structures 15, separated by a thin dielectric spacing. The dielectric spacing is formed by the SiN spacers 5 and the high-k dielectric conformal layer. In other words, the core of the dielectric spacing is formed by SiN, the original spacer material, which is due to the fact that the spacer material is essentially not oxidized during the thermal oxidation steps for forming layers 6 and 10. Any conductive layers comprised in the conformal layer 11 on top of the high-k dielectric are to be considered as part of the conductive structures 15.

The formation of the high-k layer, possible further conformal layers and the W-layer is known from the prior art as part of the replacement metal gate (RMG) technique, and details of the various steps may be performed according to this known technology. Variations which differ from the standard RMG technique are however possible. For example, the conformal layer 11 may consist only of electrically conductive material, and/or the non-conformal layer 12 could be a layer of polycrystalline silicon. After the thinning and planarization step, a dopant implantation step may then be performed to obtain a desired degree of conductivity of the doped polySi portions 15.

The remainder of the fabrication of the quantum dot device from the array of spaced-apart structures 15 illustrated in Figure 12 is not the focus of this application. The device can be obtained using known techniques in accordance with a desired quantum dot device configuration, including any configuration known in the art. The array of structures 15 may for example be further processed by cutting the structures according to a given layout, and contacting them can be done by producing a back end of line structure comprising interconnect vias and lines on top of the structures, so that the structures 15 effectively become the gate structures of the quantum dot device, configured to trap quantum dots at the interface between the gate oxide layer 10 and the Si substrate 1.

The formation of the gate structures 15 in the above-described way results in gate structures having a uniform height, i.e. all structures have essentially the same height apart from the small level difference described above which is however negligible compared to the height difference between the gates in quantum dot devices obtained by prior art methods. Also, the spacing between adjacent structures is constant across the array of gate structures 15 and constant along the height of the structures. This is an improvement over existing fabrication methods, as it enables a higher degree of reliability of the quantum dot device operation.

The substrate 1 need not be a substrate formed entirely of the semiconductor material that is to be oxidized to form the gate oxide layer 10. It is sufficient that the substrate comprises a top layer of said semiconductor material. For example, the substrate could be an SOI (silicon-on-insulator) substrate. The substrate 1 is not limited to a silicon substrate, but it may be formed or have a top layer of another semiconductor material.

The invention is not limited to mandrel structures consisting of the thin silicon oxide layer 4a and the thicker portion 4b formed of aSi or polySi. The mandrels 4 could be formed of multiple layers of various thicknesses, or of a single material, for example a single layer of aSi or polySi or amorphous carbon. In the latter case (mandrels formed of a single material), the removal of the mandrels takes place in a single removal step, with respect to the spacers and with respect to the auxiliary layer 6.

The auxiliary layer 6 can be formed of any material that enables the selective removal of the thicker portion 4b of the mandrels (if these consist of portions 4a and 4b), or the selective removal of the complete mandrels, if these consist of a single layer. Layer 6 may be applied by any suitable technique that is applicable for the chosen material of said layer 6, for example by deposition or by growth using O₂ plasma.

The invention is related also to a quantum dot device obtainable by the method of the invention. The device comprises an array of gate structures overlying a gate oxide layer of constant thickness obtained by thermal oxidation, therefore having a low defect density. The gate structures have a uniform height as well as a uniform dielectric spacing between adjacent structures. The characteristics of the quantum dot device are therefore as follows:
- the gate oxide layer has a constant thickness,
- the height of the gate structures is essentially constant (i.e. all structures have essentially the same height),
- the spacing between adjacent gate structures is the same between each pair of adjacent gate structures and constant along the height of the gate structures

In the present description and in the appended claims, a 'thin layer', such as layers 4a and 6 in the above-described embodiments, is defined as a layer that is thinner than the width (i.e. the width wₛ as shown in Figure 3) of the spacers 5, determined at the time of their creation on the sides of the mandrel structures 4. According to embodiments of the invention, the thin layer has at least half of the width of the spacers. According to specific embodiments, said thickness is less than 1/3 or less than 1/4 or less than 1/5 of the spacer width. According to embodiments of the invention, the 'thin layer' (such as layers 4a and 6) is between 1 nm and 10 nm in thickness.

While the invention has been illustrated and described in detail in the drawings and foregoing description, such illustration and description are to be considered illustrative or exemplary and not restrictive. Other variations to the disclosed embodiments can be understood and effected by those skilled in the art in practicing the claimed invention, from a study of the drawings, the disclosure, and the appended claims. In the claims, the word "comprising" does not exclude other elements or steps, and the indefinite article "a" or "an" does not exclude a plurality. The mere fact that certain measures are recited in mutually different dependent claims does not indicate that a combination of these measures cannot be used to advantage. Any reference signs in the claims should not be construed as limiting the scope.

When it is stated that a layer is formed 'on' a substrate, this includes the case wherein said layer replaces a top portion of said substrate, as in the case of a thermal oxidation.

## Claims

1. A method for producing a quantum dot device according to a pre-defined quantum dot device configuration, said configuration comprising an array of mutually parallel electrically conductive gate structures separated from each other by a dielectric-filled spacing the method comprising the steps of:
- providing a substrate (1) consisting of a semiconductor material or comprising a top layer formed of a semiconductor material,
- producing a plurality of parallel mandrel structures (4) on the substrate (1),
- producing spacers (5) formed of a dielectric material on the side surfaces of the mandrel structures (4), said spacers having a given width,
- forming a thin auxiliary layer (6) on the mandrel structures (4) and on the substrate (1), said auxiliary layer (6) being thinner than said spacer width,
- removing said auxiliary layer (6) from the mandrel structures (4) while substantially maintaining it on the substrate (1),
- selectively removing at least a top layer of the mandrel structures (4), wherein said removal is selective with respect to the spacers (5) and with respect to said auxiliary layer (6),
- removing said auxiliary layer (6) from the substrate (1), and if any remaining portions of the mandrel structures (4) are still present, removing said remaining portions,
- producing an oxide layer (10) in the areas between the spacers (5), by thermal oxidation of said semiconductor material, wherein the oxide layer (10) is thinner than the height of the spacers (5) so that the spacers and the oxide layer define a topology,
- filling up the areas between the spacers (5) by depositing one or more conformal layers (11) which follow said topography, and thereafter depositing a non-conformal layer (12) that covers the spacers (5),
- thinning and planarizing the non-conformal layer (12) until structures (15) are obtained, formed at least partially of the material of the non-conformal layer (12) and separated from each other by at least said dielectric material of the spacers (5),
- starting from the result of the thinning and planarization step, producing said predefined quantum dot device configuration wherein :
∘ the structures (15) or portions thereof act as the gate structures of the quantum dot device,
∘ the thermally grown oxide layer (10) acts as a gate oxide layer,
∘ the spacers (5) act as at least part of said dielectric-filled spacing between the gate structures.

2. The method according to claim 1, wherein said auxiliary layer (6) is a thin layer of oxide of said semiconductor material, and wherein said layer (6) is formed by a thermal oxidation step.

3. The method according to claim 1 or 2, wherein the mandrel structures (4) comprise a thin layer (4a) of oxide on the substrate (1) and a thicker layer (4b) on top of the thin oxide layer (4a) , and wherein the method comprises :
- removing said thicker layer (4b) of the mandrel structures selectively with respect to the spacers (5) and with respect to the thin auxiliary layer (6),
- thereafter, removing the thin oxide layer (4a) of the mandrel structures (4) and the auxiliary layer (6) prior to the step of forming the gate oxide layer (10).

4. The method according to any one of the preceding claims, wherein the substrate (1) is a silicon substrate or comprises a top layer formed of silicon.

5. The method according to claim 3, wherein the substrate (1) is a silicon substrate or comprises a top layer formed of silicon, and wherein the mandrel structures (4) consist of said thin oxide layer (4a), being a thin silicon oxide layer, and of said thicker layer (4b) formed of amorphous silicon or polycrystalline silicon.

6. The method according to any one of the preceding claims, wherein the width of said mandrel structures (4) is between 10 and 50 nm and wherein the width of the spacers (5) is between 4 and 30 nm.

7. The method according to any one of the preceding claims, wherein the mandrel structures (4) all have the same width, and wherein said mandrel structures are arranged in a regular array having a constant pitch of at least twice said width.

8. The method according to any one of the preceding claims, wherein the non-conformal layer (12) is an electrically conductive layer, so that the structures (15) obtained after thinning and planarization are electrically conductive structures.

9. The method according to any one of claims 1 to 6, wherein the non-conformal layer (12) is a non-electrically conductive layer, and wherein dopant elements are implanted in the structures (15) obtained by thinning and planarization, so that said structures become electrically conductive.

10. The method according to any one of the preceding claims, wherein one or more of the structures (15) obtained after thinning and planarization are cut to form separate portions of said structures, and wherein one or more of said portions act as said gate structures of the quantum dot device.

11. A quantum dot device comprising an array of mutually parallel gate structures (15), said gate structures being separated from each other by a dielectric spacing and located on and in physical contact with a gate oxide layer (10) that is on and in physical contact with a substrate (1), the substrate comprising at least a top layer formed of a semiconductor material, the gate oxide layer (10) being formed of an oxide of said semiconductor material, **characterized in that** :
• the gate oxide layer (10) has a constant thickness,
• the gate structures (15) have essentially the same height,
• the width of the dielectric spacing is the same between each pair of adjacent gate structures and constant along the height of the gate structures.

12. The device according to claim 11, wherein the substrate (1) is a silicon substrate or comprises a top layer formed of silicon.

13. The device according to claim 11 or 12, wherein the width of said gate structures (15) is between 10 and 50 nm and wherein the width of the dielectric spacing is between 4 and 30 nm.
